# EUROPÄISCHE PATENTANMELDUNG

(11) **EP 2 966 481 A1**
(43) Veröffentlichungstag der Anmeldung: **13.01.2016**
(21) Anmeldenummer: 15164083.6
(22) Anmeldetag: 17.04.2015
(51) Int. Cl.: G02B 1/118, G02B 1/12

(54) **VERFAHREN ZUR HERSTELLUNG EINER ENTSPIEGELUNGSSCHICHT AUF EINER SILIKONOBERFLÄCHE UND OPTISCHES ELEMENT**

(30) Priorität: 28.04.2014 DE 102014105939
(71) Anmelder: Fraunhofer-Gesellschaft zur Förderung der angewandten Forschung e.V., 80686 München (DE)
(72) Erfinder: Schulz, Ulrike, 07751 Jena (DE); Rickelt, Friedrich, 07745 Jena (DE); Munzert, Peter, 07743 Jena (DE); Kaiser, Norbert, 07745 Jena (DE)
(74) Vertreter: Epping - Hermann - Fischer

(57) **Zusammenfassung**

Es wird ein Verfahren zur Herstellung einer Entspiegelungsschicht auf einer Silikonoberfläche (7) angegeben, umfassend die Verfahrensschritte Aufbringen einer organischen Schicht (1), Erzeugung einer Nanostruktur (11) in der organischen Schicht (1) mit einem Plasmaätzprozess und Aufbringen mindestens einer Deckschicht (4) auf die Nanostruktur (11). Weiterhin wird ein mit dem Verfahren herstellbares optisches Element beschrieben.

## Beschreibung

Die Erfindung betrifft ein Verfahren zur Herstellung einer Entspiegelungsschicht auf einer Silikonoberfläche und ein optisches Element mit einer Silikonoberfläche und einer darauf aufgebrachten Entspiegelungsschicht.

Diese Patentanmeldung beansprucht die Priorität der deutschen Patentanmeldung 10 2014 105 939.5, deren Offenbarungsgehalt hiermit durch Rückbezug aufgenommen wird.

Silikone sind synthetische Poly(organo)siloxane, bei denen Siliziumatome über Sauerstoffatome verknüpft sind (anorganische Polymere). Silikone werden bereits seit vielen Jahrzehnten industriell genutzt. Jedoch erst seit einigen Jahren erlangen Silikone eine zunehmende Bedeutung für optische Anwendungen. Hauptsächlich im Automobilbau, im Bereich der LED-Lichttechnik sowie für Optiken für Solaranwendungen werden hochtransparente Materialien benötigt, die auch bei erhöhter Temperatur (> 100 °C) lange Zeit ihre Eigenschaften bewahren. Silikone unterscheiden sich grundsätzlich von der Klasse der Thermoplaste und auch von der Klasse der anorganischen Gläser. Als anorganische Polymere bilden sie feste Phasen weit oberhalb des Glasübergangspunktes, während sowohl Thermoplaste als auch anorganische Gläser nur unterhalb der Glasübergangstemperatur formstabil sind. Aus dieser Tatsache leitet sich die sehr hohe Wärmebeständigkeit der Silikone bei Erhalt des glasklaren optischen Eindrucks ab.

Seit kurzem sind neuartige hochtransparente Flüssigsilikone auf dem Markt, die unter anderem in speziellen Spritzgussprozessen zu hochpräzisen optischen Teilen verarbeitet werden können.

Ein zentrales Thema für optische Anwendungen ist die Entspiegelung, denn an jeder Oberfläche im optischen System gehen ohne Entspiegelung mehrere Prozent des einfallenden Lichtes durch Reflexion verloren. Alle Silikone zeigen ein gewisses elastisches Verhalten und eine relativ hohe thermische Ausdehnung. Eine dauerhafte Verbundbildung mit starren spröden Schichten, wie sie konventionelle optische Interferenzschichten aus Oxiden darstellen, ist daher schwierig zu realisieren. Spröde Oxidschichten brechen und bilden Risse, sobald sich das Substrat verformt. Aus Silikon-Bauteilen treten außerdem oft noch niedermolekulare Verbindungen aus. Diese erschweren die haftfeste Anbindung von Beschichtungen. Weiterhin sind Silikonoberflächen in der Regel sehr unpolar und damit nicht ohne Aktivierung zu benetzen und zu beschichten.

Es gibt daher keine Beispiele, bei denen Silikone mit konventionellen Interferenzschichtsystemen im Vakuum mit dem Ziel der Entspiegelung beschichtet wurden.

In den Druckschriften DE 10241708 B4 und EP 2083991 B1 werden Verfahren beschrieben, bei denen an der Oberfläche eines Kunststoffsubstrats mittels eines Plasmaätzprozesses eine Nanostruktur erzeugt wird, durch die die Reflexion des Kunststoffsubstrats vermindert wird. Ein solcher Plasmaätzprozess ist aber nicht für das Ätzen von Silikonoberflächen geeignet.

Der Erfindung liegt die Aufgabe zugrunde, ein Verfahren anzugeben, mit dem eine temperaturstabile Entspiegelungsschicht auf einer Silikonoberfläche herstellbar ist, die eine Entspiegelung in einem großen Wellenlängen- und Einfallswinkelbereich bewirkt. Weiterhin soll ein optisches Element mit einer derartigen Entspiegelungsschicht angegeben werden.

Diese Aufgaben werden durch ein Verfahren und ein optisches Element gemäß den unabhängigen Patentansprüchen gelöst. Vorteilhafte Ausgestaltungen und Weiterbildungen der Erfindung sind Gegenstand der abhängigen Ansprüche.

Gemäß zumindest einer Ausführungsform umfasst das Verfahren zur Herstellung einer Entspiegelungsschicht auf einer Silikonoberfläche das Aufbringen einer organischen Schicht und die Erzeugung einer reflexionsmindernden Nanostruktur in der organischen Schicht mit einem Plasmaätzprozess. Die reflexionsmindernde Nanostruktur wird bei dem Verfahren vorteilhaft nicht in der Silikonoberfläche, sondern in einer darauf aufgebrachten organischen Schicht erzeugt.

Die organische Schicht weist vorteilhaft ein organisches Material auf, das sich durch eine thermische Beständigkeit bis zu einer Temperatur von mindestens 150 °C, bevorzugt mindestens 200 °C, auszeichnet. Besonders bevorzugt enthält die organische Schicht Melamin (2,4,6-Triamino-1,3,5-triazin), MBP (5,5'-Di(4-biphenylyl)-2,2'-bithiophen), TPD (N,N'-Bis(3-methylphenyl)-N,N'-diphenyl-benzidin), NPB (N,N-Di(naphth-1-yl)-N,N'-diphenyl-benzidin), TPB (N,N,N',N'-Tetraphenylbenzidin), TCTA (Tris(4-carbazoyl-9-ylphenyl)amin), B2TP (5,5'-Di-(4-byphenylyl)-2,2'-bithiophen, Parylen.

Die organische Schicht wird vorzugsweise in einem Vakuumprozess aufgebracht, beispielsweise durch thermisches Verdampfen. Die organische Schicht weist vorzugsweise eine Dicke von 150 nm bis 300 nm auf.

Nach der Herstellung der Nanostruktur in der organischen Schicht wird vorteilhaft in einem weiteren Verfahrensschritt eine Deckschicht aufgebracht. Die Deckschicht ist vorzugsweise nicht mehr als 40 nm dick. Besonders vorteilhaft ist eine Dicke zwischen 10 nm und 40 nm. In diesem Bereich ist die Deckschicht einerseits dick genug, um einen Schutz der Nanostruktur zu gewährleisten, andererseits aber noch dünn genug, um die reflexionsminderende Wirkung der Nanostruktur nicht oder nicht wesentlich zu beeinträchtigen.

Die Deckschicht enthält vorzugsweise ein Siliziumoxid oder ein Aluminiumoxid. Die Deckschicht kann alternativ aus einm Plasmapolymer gebildet sein, das Siloxan-Monomere wie beispielsweise TMS (Tetramethylsilan) oder HMDSO(Hexamethyldisiloxan) aufweist.

Es hat sich herausgestellt, dass durch das Aufbringen einer organischen Schicht, in der durch einen Plasmaätzprozess eine Nanostruktur erzeugt werden kann, und das nachfolgende Aufbringen einer Deckschicht eine gute Entspiegelungswirkung für eine Silikonoberfläche über einen großen Winkel- und Wellenlängenbereich erzielt werden kann. Weiterhin zeichnet sich die Entspiegelungsschicht durch eine hohe Temperaturbeständigkeit aus, so dass die mit der Entspiegelungsschicht versehnene Silikonoberfläche dauerhaft bei einer Temperatur von mehr als 100 °C oder sogar mehr als 150 °C verwendar ist. Die Entspiegelungsschicht ist daher insbesondere für optische Elemente aus Silikon vorteilhaft, die dauerhaft bei hohen Betriebstemperaturen verwendet werden sollen.

Bei einer bevorzugten Ausgestaltung des Verfahrens wird vor dem Aufbringen der organischen Schicht die Silikonoberfläche durch Ionenbeschuss vorbehandelt. Vorzugsweise erfolgt die Vorbehandlung durch Ionenbeschuss mit Argonionen und/oder Sauerstoffionen, wobei bevorzugt Ionenenergien im Bereich von 60 eV bis 160 eV verwendet werden. Die Behandlungszeit beträgt vorteilhaft zwischen 60 Sekunden und 600 Sekunden. Durch die Vorbehandlung mittels Ionenbeschuss wird insbesondere die Haftung der nachfolgend aufgebrachten organischen Schicht auf der Silikonoberfläche verbessert.

Alternativ oder zusätzlich kann bei dem Verfahren eine Haftschicht auf die Silikonoberfläche aufgebracht werden. Die Haftschicht weist bevorzugt eine Dicke von nicht mehr als 50 nm, besonders bevorzugt zwischen 5 nm und 15 nm, auf. Die Haftschicht enthält bei einer bevorzugten Ausgestaltung ein Siliziumoxid, zum Beispiel SiO₂, SiO oder SiOₓ. Die Haftschicht kann zum Beispiel durch thermisches Aufdampfen oder durch Plasmapolymerisation aus Siloxan-Monomeren erzeugt werden.

Die in der organischen Schicht erzeugte Nanostruktur weist vorzugsweise mindestens eine Tiefe von 30 nm auf. Mit anderen Worten erstreckt sich die Nanostruktur von der Oberfläche der organischen Schicht mindestens 30 nm tief in die organische Schicht hinein. Durch eine derartige Nanostruktur wird insbesondere erreicht, dass die nanostrukturierte organische Schicht eine geringere effektive Brechzahl als eine homogene Schicht aus dem Material der organischen Schicht aufweist. Insbesondere weist die nanostrukturierte organische Schicht eine effektive Brechzahl auf, die geringer als die Brechzahl von Silikon ist.

Bei einer vorteilhaften Ausgestaltung des Verfahrens wird nach der Erzeugung der Nanostruktur eine zweite organische Schicht auf die Nanostruktur aufgebracht, wobei eine zweite Nanostruktur in der zweiten organischen Schicht mittels eines zweiten Plasmaätzprozesses erzeugt wird.

Bei einer bevorzugten Ausgestaltung des Verfahrens wird vor dem Aufbringen der zweiten organischen Schicht eine Ätzstoppschicht auf die Nanostruktur aufgebracht. Durch die Ätzstoppschicht wird vorteilhaft verhindert, dass Teile der Nanostruktur bei der Durchführung des zweiten Plasmaätzprozesses abgetragen werden. Die Ätzstoppschicht weist vorzugsweise eine Dicke von nicht mehr als 30 nm auf. Eine derart geringe Dicke der Ätzstoppschicht hat den Vorteil, dass die effektive Brechzahl im Grenzbereich zwischen der Nanostruktur und der zweiten Nanostruktur nur unwesentlich beeinflusst wird. Bei der Ätzstoppschicht kann es sich beispielsweise um eine SiO₂-Schicht handeln.

Die zweite organische Schicht weist bei dem zweiten Plasmaätzprozess vorzugsweise eine größere Ätzrate auf als die zuvor aufgebrachte organische Schicht unter den gleichen Prozessbedingungen. Durch den zweiten Plasmaätzprozess wird in der zweiten organischen Schicht vorzugsweise eine Nanostruktur erzeugt, durch die in der zweiten organischen Schicht eine noch geringere effektive Brechzahl als in der ersten organischen Schicht erzeugt wird. Auf diese Weise wird eine besonders gute Entspiegelungswirkung an der Silikonoberfläche erzielt.

Die nach der Erzeugung der Nanostruktur oder gegebenenfalls nach der Erzeugung der zweiten Nanostruktur aufgebrachte Deckschicht weist bevorzugt eine Dicke von nicht mehr als 40 Nanometer auf. Die Deckschicht kann insbesondere die Funktion einer Schutzschicht für die mindestens eine nanostrukturierte organische Schicht haben. Weiterhin kann die Deckschicht vorteilhaft eine Antibeschlagschicht oder eine hydrophobe Schicht sein. Beispielsweise verleiht eine mindestens 10 nm dicke Deckschicht aus SiO₂ der Oberfläche dauerhaft Antibeschlageigenschaften. Eine hydrophobe Oberfläche kann insbesondere durch das Aufbringen einer fluorhaltigen Polymerschicht erzielt werden. Bei dieser Ausgestaltung ist die fluorhaltige Polymerschicht vorzugsweise zwischen 5 nm und 10 nm dick. Eine hydrophobe Oberfläche hat den Vorteil, dass Wasser leicht von der Oberfläche abperlen kann.

Das Verfahren ist insbesondere dazu geeignet, ein optisches Element aus einem Silikon mit einer Entspiegelungsschicht zu versehen. Das mit dem Verfahren entspiegelte optische Element weist eine Silikonoberfläche und eine auf die Silikonoberfläche aufgebrachte Entspiegelungsschicht auf, wobei die Entspiegelungsschicht eine organische Schicht mit einer Nanostruktur mit einer Tiefe von mindestens 30 nm und eine der organischen Schicht nachfolgende Deckschicht, die eine Dicke von nicht mehr als 40 nm aufweist, umfasst. Weitere vorteilhafte Ausgestaltungen des optischen Elements ergeben sich aus der vorherigen Beschreibung des Verfahrens und umgekehrt.

Das optische Element zeichnet sich insbesondere dadurch aus, dass die Restreflexion über einen großen Wellenlängen- und Winkelbereich sehr gering ist und das optische Element dauerhaft bei hohen Temperaturen von mehr als 100 °C oder sogar mehr als 150 °C verwendet werden kann. Die Silikonoberfläche des optischen Elements kann insbesondere eine gekrümmte Oberfläche oder eine mikrostrukturierte Oberfläche sein, ohne dass die reflexionsmindernde Wirkung der Entspiegelungsschicht wesentlich beeinträchtigt wird.

Die Erfindung wird im Folgenden anhand von Ausführungsbeispielen im Zusammenhang mit den Figuren 1 bis 4 näher erläutert.

Es zeigen:
Figuren 1A bis 1E eine schematische Darstellung eines Verfahrens zur Herstellung einer Entspiegelungsschicht gemäß einem ersten Ausführungsbeispiel anhand von Zwischenschritten,
Figur 2 die Reflexion R in Abhängigkeit von der Wellenlänge λ von einem optischen Element mit einer Entspiegelungsschicht gemäß einem Ausführungsbeispiel im Vergleich zu einer unbeschichteten Silikonoberfläche,
Figuren 3A bis 3F eine schematische Darstellung eines Verfahrens zur Herstellung einer Entspiegelungsschicht gemäß einem weiteren Ausführungsbeispiel anhand von Zwischenschritten, und
Figur 4 die Reflexion R in Abhängigkeit von der Wellenlänge λ für ein optisches Element mit einer Entspiegelungsschicht gemäß einem Ausführungsbeispiel im Vergleich zu einer unbeschichteten Silikonoberfläche bei Einfallswinkeln von 0° und 45°.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

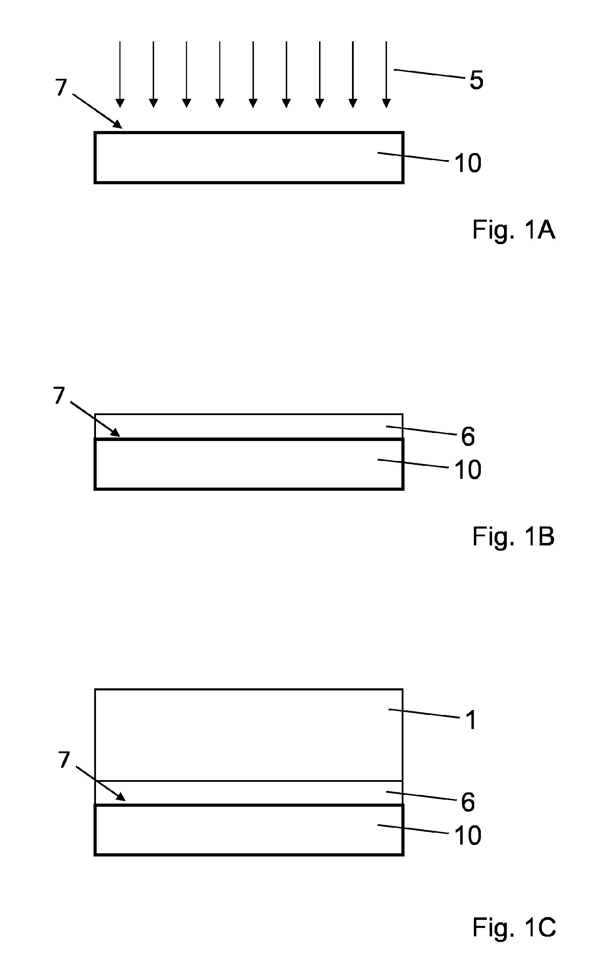

Bei dem in den Figuren 1A bis 1E dargestellten Verfahren gemäß einem Ausführungsbeispiel wird eine Silikonoberfläche 7 mit einer Entspiegelungsschicht versehen. Die Silikonoberfläche 7 ist die Oberfläche eines Substrats 10, das ein Silikon aufweist oder daraus besteht. Das Silikon kann insbesondere Siloxan-Einheiten der allgemeinen Formel R₃Si-[O-SiR₂]n-O-SiR₃ aufweisen, wobei R Wasserstoffatome oder Alkylgruppen sein können. Das Silikon kann zum Beispiel ein Verguss-Silikon sein, das UV-härtend, thermisch härtend oder additionsvernetzend bei Raumtemperatur ist. Beispiele solcher Silikone sind Poly(dimethylsiloxan) (PDMS) oder die unter den Bezeichnungen Wacker SilGel, Wacker SEMICOSIL, Bluesil- 2-Komponenten-Vergussmasse, RTV 615 oder Sylgard 184 erhältlichen Silikone. Weiterhin sind Silikone geeignet, die für die Verarbeitung im Spritzguss vorgesehen sind. Solche Silikone sind zum Beispiel unter folgenden Bezeichnungen erhältlich: Dow Corning MS1001, M1002, M1003, Wacker LUMISIL (z.B. LUMISIL 419 UV, LUMISIL LR 7600).

Das Substrat 10 kann insbesondere ein optisches Element sein, das zum Beispiel für eine Anwendung in der Beleuchtungstechnik, der Solartechnik, der Automobiltechnik oder der Medizintechnik vorgesehen sein kann. Anders als bei dem dargestellten Ausführungsbeispiel ist es insbesondere möglich, dass das optische Element 10 eine gekrümmte Oberfläche und/oder eine mikrostrukturierte Oberfläche aufweist.

Wie in Figur 1A dargestellt, erfolgt in einem ersten Zwischenschritt vorteilhaft eine Vorbehandlung der Silikonoberfläche 7 durch einen Ionenbeschuss, der durch die Pfeile 5 angedeutet wird. Der Ionenbeschuss erfolgt vorzugsweise mit Argonionen und/oder Sauerstoffionen, welche Ionenenergien im Bereich von 60 eV bis 160 eV aufweisen. Bevorzugt wird die Silikonoberfläche 7 während einer Behandlungszeit zwischen 60 Sekunden und 600 Sekunden durch den Ionenbeschuss vorbehandelt.

In einem weiteren in Figur 1B dargestellten Zwischenschritt des Verfahrens wird vorteilhaft eine Haftschicht 6 auf die Silikonoberfläche 7 aufgebracht. Die Haftschicht 6 ist vorteilhaft nicht mehr als 50 nm, vorzugsweise zwischen 5 nm und 15 nm dick. Vorteilhaft wird als Haftschicht eine Siliziumoxidschicht, zum Beispiel SiO₂, SiO oder SiOₓ, verwendet. Die Haftschicht 6 kann thermisch aufgedampft werden oder alternativ beispielsweise durch Plasmapolymerisation aus Siloxan-Monomeren wie beispielsweise TMS oder HMDSO hergestellt werden.

In einem weiteren, in Figur 1C dargestellten Zwischenschritt, wird eine organische Schicht 1 auf die Haftschicht 6 aufgebracht, die vorzugsweise eine Dicke zwischen 150 nm und 300 nm aufweist. Die organische Schicht ist vorteilhaft aus einem temperaturbeständigen organischen Material gebildet. Insbesondere kann die organische Schicht 1 Melamin (2,4,6-Triamino-1,3,5-triazin), MBP (5,5'-Di(4-biphenylyl)-2,2'-bithiophen), TPD (N,N'-Bis(3-methylphenyl)-N,N'-diphenyl-benzidin), NPB (N,N-Di(naphth-1-yl)-N,N'-diphenyl-benzidin), TPB (N,N,N',N'-Tetraphenylbenzidin), TCTA (Tris(4-carbazoyl-9-ylphenyl)amin), B2TP (5,5'-Di-(4-byphenylyl)-2,2'-bithiophen, HMDSO (Hexamethyldisiloxan) oder Parylen aufweisen.

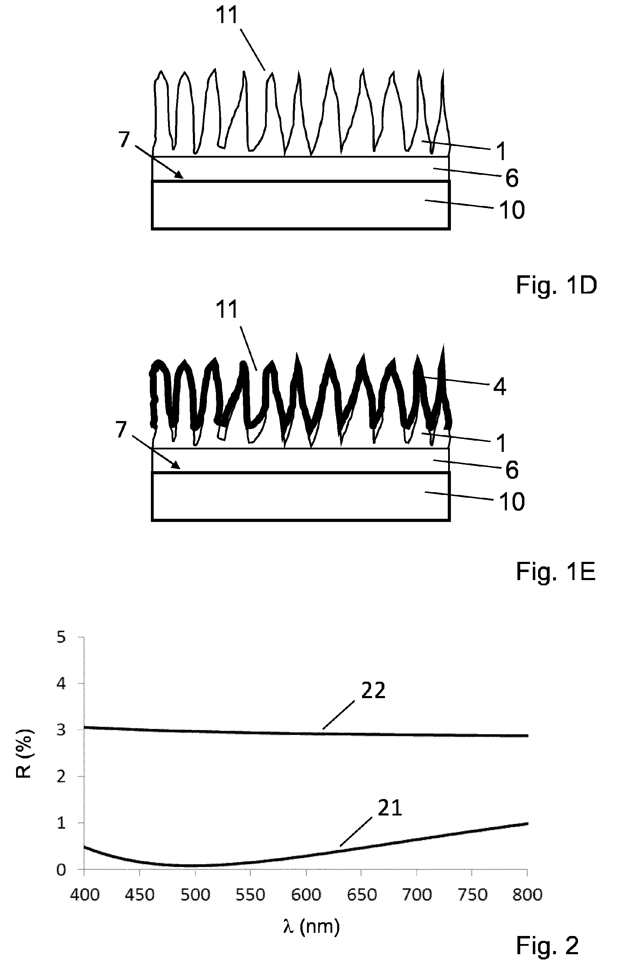

Bei dem in Figur 1D dargestellten weiteren Zwischenschritt ist in der organischen Schicht 1 eine Nanostruktur 11 mittels eines Plasmaätzprozesses erzeugt worden. Bei dem Plasmaätzprozess wird die organische Schicht 10 beispielsweise mittels einer Plasmaionenquelle mit Ionen beschossen, um die erste Nanostruktur 11 zu erzeugen. Ein solcher Plasmaätzprozess ist an sich aus den in der Beschreibungseinleitung zitierten Druckschriften DE 10241708 B4 oder EP 2083991 B1 bekannt und wird daher nicht näher erläutert.

Die Nanostruktur 11 weist vorteilhaft eine Vielzahl von Erhebungen und Vertiefungen auf, wobei sich die Vertiefungen vorzugsweise bis in eine Tiefe von mindestens 30 nm, insbesondere etwa 30 nm bis 130 nm, in die organische Schicht hinein erstrecken. Durch die Nanostruktur 11 ist der effektive Brechungsindex in der organischen Schicht 1 vorteilhaft geringer als der Brechungsindex der organischen Schicht 1 vor der Durchführung des Plasmaätzprozesses. Insbesondere weist die nanostrukturierte organische Schicht 1 eine effektive Brechzahl auf, die geringer als die Brechzahl von Silikon ist. Die mit der Nanostruktur 11 versehene organische Schicht 1 kann insbesondere einen Brechzahlgradienten aufweisen, wobei die Brechzahl in einer von der Silikonoberfläche 7 weg zeigenden Richtung abnimmt.

In einem weiteren Verfahrensschritt, der in Figur 1E dargestellt ist, wird eine Deckschicht 4 auf die Nanostruktur 11 aufgebracht. Die Deckschicht 4 kann insbesondere als Schutzschicht für die Nanostruktur 11 fungieren. Weiterhin kann die Deckschicht 4 vorteilhaft auch andere Funktionalitäten der Oberfläche bewirken, insbesondere kann sie als Antibeschlagschicht oder als hydrophobe Schicht fungieren. Die Deckschicht 4 ist vorteilhaft nicht mehr als 40 nm, bevorzugt zwischen 10 nm und 40 nm dick. Aufgrund der vergleichsweise geringen Dicke bildet die Deckschicht 4 die Nanostruktur 11 der organischen Schicht 1 im Wesentlichen konform nach. Insbesondere wird die Nanostruktur 11 durch die Deckschicht 4 nicht planarisiert. Die Deckschicht 4 kann eine anorganische Schicht aufweisen, insbesondere eine Oxidschicht wie zum Beispiel SiO₂ oder Al₂O₃. Die Deckschicht 4 wird vorzugsweise wie die zuvor aufgebrachten Schichten in einem Vakuumverfahren aufgebracht, so dass vorteilhaft die gesamte Entspiegelungsschicht in einem Vakuumprozess erzeugt werden kann.

Es ist auch denkbar, dass die Deckschicht 4 aus mehreren dünnen Teilschichten gebildet wird, wobei vorzugsweise die Gesamtdicke der Deckschicht nicht mehr als 40 nm beträgt. Die Deckschicht kann zum Beispiel eine mindestens 10 nm dicke SiO₂-Schicht aufweisen, welche der Oberfläche dauerhaft Antibeschlageigenschaften verleiht. Nachfolgend kann als weitere Teilschicht der Deckschicht zum Beispiel ein fluorhaltiges Polymer aufgebracht werden, wobei die fluorhaltige Polymerschicht bevorzugt eine Dicke zwischen 5 nm und 10 nm aufweist. Die fluorhaltige Polymerschicht bewirkt vorteilhaft eine Hydrophobisierung der Oberfläche, so dass Wasser von der Oberfläche leicht abperlen kann.

In Figur 2 ist die Reflexion in Abhängigkeit von der Wellenlänge λ im sichtbaren Spektralbereich für eine Folie aus einem Silikon, die gemäß einem Verfahren nach den Figuren 1A bis 1E mit einer Entspiegelungsschicht versehen wurde, dargestellt (Kurve 21). Zum Vergleich ist weiterhin die Reflexion der unbeschichteten Silikonfolie (Kurve 22) dargestellt. Zur Herstellung der Entspiegelungsschicht auf der Silikonfolie wurde in einem ersten Schritt in einer Vakuumaufdampfanlage vom Typ APS 904 (Leybold-Optics) eine Vorbehandlung durch Ionenbeschuss mit Argonionen und Sauerstoffionen für 100 Sekunden mit einer Ionenenergie von 1 eV bei einer Bias-Spannung von 100 V durchgeführt. Anschließend wurde ein 10 nm dicke SiO₂-Schicht als Haftschicht abgeschieden. In einem weiteren Schritt wurde eine 150 nm dicke Schicht aus Melamin mit einer Aufwachsrate von 0,3 nm pro Sekunde aufgedampft.

Nachfolgend wurde mittels einer Plasmaionenquelle ein Plasmaätzprozess durchgeführt, um eine Nanostruktur in der organischen Schicht aus Melamin zu erzeugen. Zur Erzeugung des Plasmas wurden Argon mit einer Flussrate von 13 sccm und Sauerstoff mit einer Flussrate 30 sccm in die Vakuumanlage eingelassen. Die Plasmaionenquelle wurde mit einer Bias-Spannung, die ein Maß für die Energie der auf die Oberfläche treffenden Ionen ist, von 120 V bei einem Entladestrom von 50 A betrieben. Der Plasmaätzprozess wurde 300 Sekunden lang durchgeführt, wonach die Dicke der Melamin-Schicht etwa 130 nm und die effektive Brechzahl der nanostrukturierten Melamin-Schicht etwa 1,1 beträgt. Als Deckschicht wurde eine 20 nm dicke Schicht aus SiO₂ durch Elektronenstrahlverdampfung auf der Nanostruktur abgeschieden.

Die mittlere Restreflexion im Wellenlängenbereich von 400 nm bis 800 nm beträgt für die mit der Entspiegelungsschicht versehene Silikonfolie bei senkrechtem Lichteinfall weniger als 0,5 %. Die beschichtete Probe wurde für 1000 Stunden bei einer Temperatur von 105 °C gelagert, ohne dass sich die optischen Eigenschaften änderten. Dies verdeutlicht die hohe Temperaturbeständigkeit der Entspiegelungsschicht.

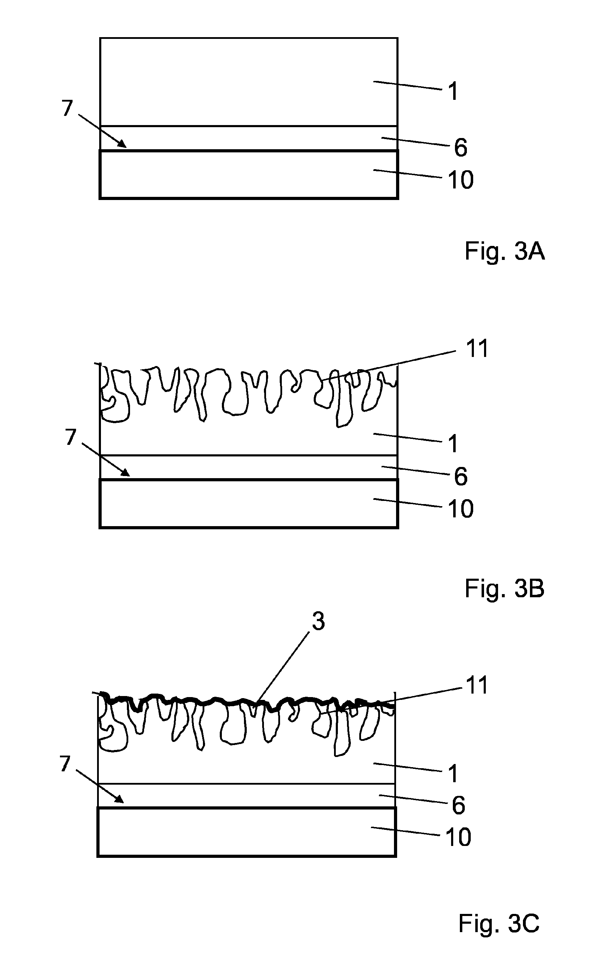

In den Figuren 3A bis 3F ist eine Abwandlung des Verfahrens zur Herstellung einer Entspiegelungsschicht dargestellt.

Wie in Figur 3A dargestellt, werden bei dem Verfahren zunächst eine Haftschicht 6 und eine organische Schicht 1 auf die Silikonoberfläche 7 eines Substrats 10, das insbesondere ein optisches Element sein kann, aufgebracht. Wie bei dem ersten Ausführungsbeispiel kann vor dem Aufbringen der Haftschicht 6 eine Vorbehandlung der Silikonoberfläche durch Ionenbeschuss erfolgen.

Bei dem in Figur 3B dargestellten Zwischenschritt ist mittels eines Plasmaätzprozesses eine Nanostruktur 11 in der organischen Schicht 1 erzeugt worden.

Anders als bei dem ersten Ausführungsbeispiel wird bei einem folgenden in Figur 3C dargestellten Zwischenschritt nicht unmittelbar eine Deckschicht auf die Nanostruktur 11 aufgebracht, sondern zunächst eine Ätzstoppschicht 3 aufgebracht, die insbesondere ein Siliziumoxid wie beispielsweise SiO₂ aufweisen kann. Die Ätzstoppschicht 3 kann zum Beispiel eine Dicke von etwa 15 nm aufweisen.

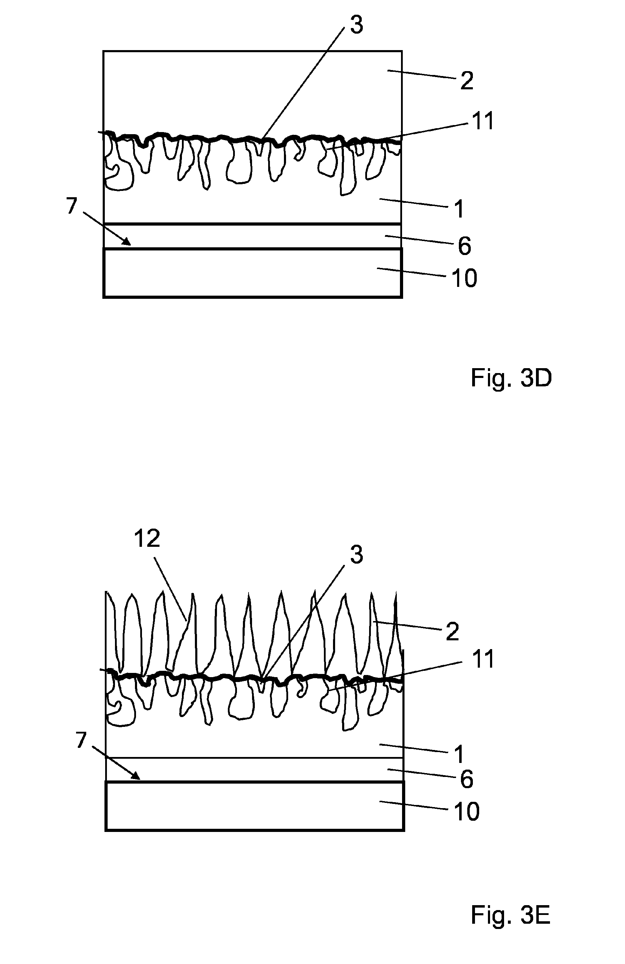

In einem weiteren in Figur 3D dargestellten Verfahrensschritt wird eine zweite organische Schicht 2 auf die mit der Nanostruktur 11 und der Ätzstoppschicht 3 versehene erste organische Schicht 1 aufgebracht.

Wie in Figur 3E dargestellt, wird in einem weiteren Verfahrensschritt mittels eines zweiten Plasmaätzprozesses eine zweite Nanostruktur 12 in der zweiten organischen Schicht 2 erzeugt.

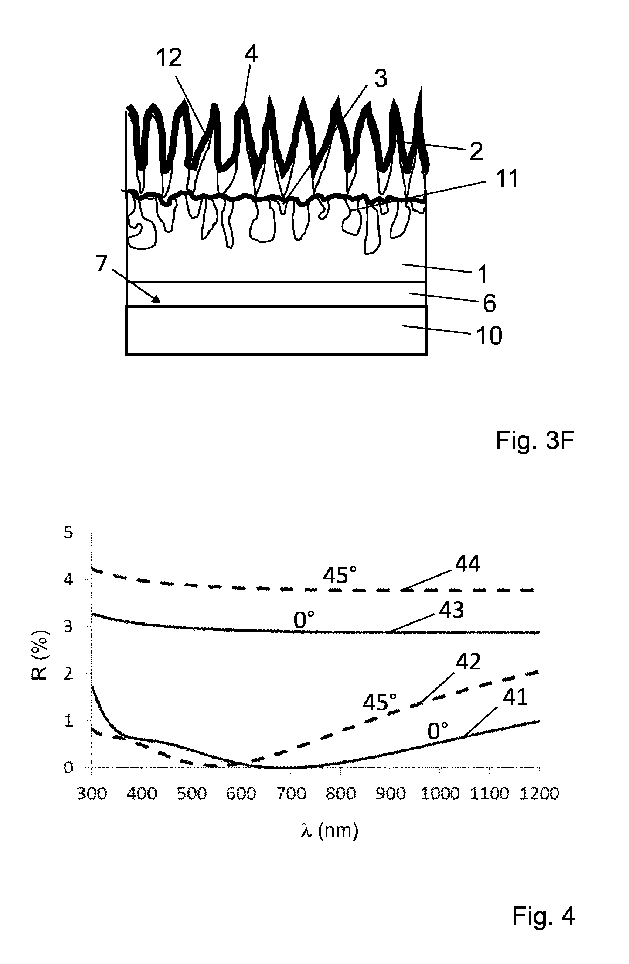

Bei dem in Figur 3F dargestellten Verfahrensschritt ist eine Deckschicht 4 auf die zweite Nanostruktur 12 aufgebracht worden, wobei die Deckschicht 4 die gleichen Ausgestaltungen und vorteilhaften Eigenschaften wie bei dem ersten Ausführungsbeispiel aufweisen kann.

Das zweite Ausführungsbeispiel unterscheidet sich somit von dem ersten Ausführungsbeispiel dadurch, dass die Entspiegelungsschicht zwei übereinander angeordnete organische Schichten 1, 2 aufweist, die jeweils durch einen Plasmaätzprozess mit Nanostrukturen 11, 12 versehen werden. Auf diese Weise kann eine besonders gute Entspiegelungswirkung erzielt werden. Vorteilhaft weist das organische Material der zweiten organischen Schicht 2 bei der Durchführung des zweiten Plasmaätzprozesses eine größere Ätzrate auf als das Material der ersten organischen Schicht 1 bei dem ersten Plasmaätzprozess. Auf diese Weise ist es insbesondere möglich, in der zweiten organischen Schicht 2 eine Nanostruktur 12 zu erzeugen, die eine noch geringere effektive Brechzahl als die mit der Nanostruktur 11 versehene erste organische Schicht 1 aufweist. Sowohl die erste organische Schicht 1 als auch die zweite organische Schicht 2 können jeweils einen Brechzahlgradienten aufweisen, wobei die Brechzahl in einer von der Silikonoberfläche 7 weg zeigenden Richtung abnimmt.

Die zweite organische Schicht 2 ist wie die erste organische Schicht 1 vorteilhaft aus einem temperaturstabilen organischen Material gebildet. Hierfür sind insbesondere die im Zusammenhang mit dem ersten Ausführungsbeispiel genannten organischen Materialien geeignet. Die Deckschicht 4 kann wie bei dem ersten Ausführungsbeispiel insbesondere zum Schutz der Nanostruktur 12 dienen und/oder Antibeschlageigenschaften oder hydrophobe Eigenschaften aufweisen.

Gemäß den in den Figuren 3A bis 3F schematisch dargestellten Verfahrensschritten wurde beispielhaft ein spritzgegossenes optisches Element aus Silikon, das eine Brechzahl n = 1,42 bei λ = 500 nm aufweist, mit der Entspiegelungsschicht versehen. Dabei wurde in einer Vakuumaufdampfanlage vom Typ APS 904 (Leybold-Optics) zunächst eine Plasmavorbehandlung durchgeführt, wobei die Silikonoberfläche für 200 Sekunden mit Ionen mit einer Ionenenergie von maximal 80 eV (eingestellt durch eine Bias-Spannung von 80 V) beschossen wurde.

Nach der Plasmavorbehandlung wurde durch Aufdampfen eine etwa 150 nm dicke organische Schicht aus MBP aufgebracht. Die Schichtdicke wurde dabei mit einem Schwingquarzmesssystem, bei dem die Massenzunahme detektiert wird, gemessen. Mittels einer Plasmaionenquelle wurde nachfolgend eine Nanostruktur in dem organischen Material MBP erzeugt. Vor der Durchführung des Plasmaätzprozesses wurde bei diesem Ausführungsbeispiel zunächst eine 2 nm dünne Schicht aus TiO₂ abgeschieden und nachfolgend der Plasmaätzprozess mittels eines Argon-Sauerstoff-Plasmas durchgeführt. Der Plasmaätzprozess wurde mit einer Bias-Spannung, die ein Maß für die Energie der auf die Oberfläche treffenden Ionen ist, von 120 V und einem Entladestrom von 50 A betrieben. Auf diese Weise wurde eine Nanostruktur mit einer Tiefe von 80 nm und einer effektiven Brechzahl von etwa 1,33 nach einer Ätzzeit von 350 Sekunden erreicht.

In einem weiteren Schritt wurde eine Ätzstoppschicht, bei der es sich um eine 15 nm dicke SiO₂-Schicht handelt, aufgedampft. In einem weiteren Schritt im selben Vakuumprozess erfolgte nachfolgend die Abscheidung einer zweiten organischen Schicht, bei der es sich um eine 250 nm dicke Melamin-Schicht handelt, durch thermisches Aufdampfen mit einer Aufwachsrate von 0,3 nm/s. Nachfolgend wurde ein zweiter Plasmaätzprozess zur Erzeugung einer Nanostruktur in der zweiten organischen Schicht aus Melamin durchgeführt. Dieser erfolgte mit einer geringeren Ionenenergie von 80 eV. Unter diesen Bedingungen wird in der organischen Schicht aus Melamin eine Ätzrate von circa 0,8 nm/s erreicht, während unter diesen Bedingungen in der darunter liegenden MBP-Schicht nur eine Dickenreduktion von weniger als 0,1 nm/s auftreten würde. Nach einer Plasmaätzzeit von 150 s beträgt die Dicke der Melamin-Schicht noch etwa 120 nm, wobei die effektive Brechzahl etwa 1,1 beträgt.

Nachfolgend wurde eine Deckschicht, bei der es sich um eine 20 nm dicke SiO₂-Schicht handelt, auf die zweite Nanostruktur aufgebracht.

In Figur 4 ist die Reflexion R der auf diese Weise mit einer Entspiegelungsschicht versehenen Silikonoberfläche im Wellenlängenbereich von 300 nm bis 1200 nm für einen Einfallswinkel von 0° (Kurve 41) und einen Einfallswinkel von 45° (Kurve 42) dargestellt. Zum Vergleich sind die Reflexion R der unbeschichteten Silikonoberfläche für den Einfallswinkel 0° (Kurve 43) und den Einfallswinkel 45° (Kurve 44) dargestellt. Die mittlere Restreflexion beträgt im Bereich von 300 nm bis 1200 nm für die mit der Entspiegelungsschicht versehene Silikonoberfläche nur weniger als 0,5 % für senkrechten Lichteinfall und weniger als 1 % für den Lichteinfallswinkel 45°.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zur Herstellung einer Entspiegelungsschicht auf einer Silikonoberfläche (7), umfassend die Verfahrensschritte:
- Aufbringen einer organischen Schicht (1),
- Erzeugung einer reflexionsmindernden Nanostruktur (11) in der organischen Schicht (1) mit einem Plasmaätzprozess, und
- Aufbringen mindestens einer Deckschicht (4) auf die Nanostruktur (11).

2. Verfahren nach Anspruch 1,
wobei die organische Schicht (1) eine thermische Beständigkeit bis zu einer Temperatur von mindestens 150 °C aufweist.

3. Verfahren nach einem der vorhergehenden Ansprüche,
wobei die organische Schicht (1) durch thermisches Verdampfen aufgebracht wird.

4. Verfahren nach einem der vorhergehenden Ansprüche,
wobei die Silikonoberfläche (7) vor dem Aufbringen der organischen Schicht (1) durch Ionenbeschuss vorbehandelt wird.

5. Verfahren nach einem der vorhergehenden Ansprüche,
wobei vor dem Aufbringen der organischen Schicht (1) eine Haftschicht (6) auf die Silikonoberfläche (7) aufgebracht wird.

6. Verfahren nach einem der vorhergehenden Ansprüche,
wobei die organische Schicht (1) eines der folgenden Materialien aufweist:
Melamin (2,4,6-Triamino-1,3,5-triazin),
MBP (5,5'-Di(4-biphenylyl)-2,2'-bithiophen),
TPD (N,N'-Bis(3-methylphenyl)-N,N'-diphenyl-benzidin),
NPB (N,N-Di(naphth-1-yl)-N,N'-diphenyl-benzidin),
TPB (N,N,N',N'-Tetraphenylbenzidin),
TCTA (Tris(4-carbazoyl-9-ylphenyl)amin),
B2TP (5,5'-Di-(4-byphenylyl)-2,2'-bithiophen), Parylen.

7. Verfahren nach einem der vorhergehenden Ansprüche,
wobei die Nanostruktur (11) eine Tiefe von mindestens 30 nm aufweist.

8. Verfahren nach einem der vorhergehenden Ansprüche,
wobei nach der Erzeugung der Nanostruktur (11) eine zweite organische Schicht (2) auf die Nanostruktur (11) aufgebracht wird, und wobei eine zweite Nanostruktur (12) in der zweiten organischen Schicht (2) mittels eines zweiten Plasmaätzprozesses erzeugt wird.

9. Verfahren nach einem der vorhergehenden Ansprüche,
wobei die Deckschicht (4) eine Dicke von nicht mehr als 40 nm aufweist.

10. Optisches Element (10) mit einer Silikonoberfläche (7) und einer auf die Silikonoberfläche (7) aufgebrachten Entspiegelungsschicht,
wobei die Entspiegelungsschicht umfasst:
- eine organische Schicht (1), die eine reflexionsmindernde Nanostruktur (11) aufweist, wobei die Nanostruktur (11) eine Tiefe von mindestens 30 nm aufweist und
- eine der organischen Schicht (1) nachfolgende Deckschicht (4), die eine Dicke von nicht mehr als 40 nm aufweist.

11. Optisches Element nach Anspruch 10,
wobei zwischen der Silikonoberfläche (7) und der organischen Schicht (1) eine Haftschicht (6) angeordnet ist.

12. Optisches Element nach Anspruch 11,
wobei die Haftschicht (6) ein Siliziumoxid aufweist.

13. Optisches Element nach Anspruch 11 oder 12,
wobei die Haftschicht (6) eine Dicke von nicht mehr als 50 nm aufweist.

14. Optisches Element nach einem der Ansprüche 10 bis 13,
wobei die organische Schicht (1) eines der folgenden Materialien aufweist:
Melamin (2,4,6-Triamino-1,3,5-triazin),
MBP (5,5'-Di(4-biphenylyl)-2,2'-bithiophen),
TPD (N,N'-Bis(3-methylphenyl)-N,N'-diphenyl-benzidin),
NPB (N,N-Di(naphth-1-yl)-N,N'-diphenyl-benzidin),
TPB (N,N,N',N'-Tetraphenylbenzidin),
TCTA (Tris(4-carbazoyl-9-ylphenyl)amin),
B2TP (5,5'-Di-(4-byphenylyl)-2,2'-bithiophen), Parylen.

15. Optisches Element nach einem der Ansprüche 10 bis 14,
wobei zwischen der organischen Schicht (1) und der Deckschicht (4) eine zweite organische Schicht (2) angeordnet ist, welche eine zweite Nanostruktur (12) aufweist.
